# EUROPEAN PATENT SPECIFICATION

(11) **EP 2 243 343 B1**
(45) Date of publication and mention of the grant of the patent: **16.11.2011**
(21) Application number: 09705910.9
(22) Date of filing: 27.01.2009
(51) Int. Cl.: H05K 9/00

(54) **ELECTROMAGNETIC INTERFERENCE SUPPRESSION SHEET COMPRISING PRESSURE-SENSITIVE ADHESIVE LAYER WITH STRUCTURED SURFACE**
ELEKTROMAGNETISCHE STÖRUNGEN UNTERDRÜCKENDE FOLIE MIT EINER SELBSTHAFTENDEN KLEBESCHICHT MIT STRUKTURIERTER OBERFLÄCHE
FEUILLE DE SUPPRESSION D'INTERFÉRENCES ÉLECTROMAGNÉTIQUES COMPRENANT UNE COUCHE D'ADHÉSIF SENSIBLE À LA PRESSION PRÉSENTANT UNE SURFACE STRUCTURÉE

(30) Priority: 29.01.2008 JP 2008017867
(43) Date of publication of application: 27.10.2010
(73) Proprietor: 3M Innovative Properties Company, Saint Paul, MN 55133-3427 (US)
(72) Inventor: MITSUI, Akihiko, Tokyo 158-8583 (JP); TAKAGI, Shuji, Tokyo 158-8583 (JP); NORO, Tetsuya, Tokyo 158-8583 (JP)
(74) Representative: Reinhard - Skuhra - Weise & Partner GbR
(86) International application number: PCT/US2009/032072
(87) International publication number: WO 2009/097250

(56) References cited:
- JP-A- 9 109 401
- JP-A- 9 312 489
- JP-A- 10 075 088
- JP-A- 2000 307 287
- US-A1- 2005 109 457
- US-B1- 6 187 120
- US-B1- 6 962 753

## Description

### Background

The present invention relates to an electromagnetic interference suppression sheet provided with a pressure-sensitive adhesive layer on one side of an electromagnetic interference suppression layer, and specifically relates to an electromagnetic interference suppression sheet having a structured surface formed on the side opposite the side in contact with the electromagnetic interference suppression layer, i.e. the side that bonds with its adherend.

### Summary

In recent years, digital electronic devices have come to employ electromagnetic interference suppression sheets that suppress unwanted electromagnetic wave interference and transmission noise passing through wirings. An example of an electromagnetic interference suppression sheet structure is described in Japanese Unexamined Patent Publication HEI No. 07-212079, as an "electromagnetic wave interference suppressor that has an electromagnetic shielding effect, comprising a conductive support, and an insulating soft magnetic material layer provided on at least one surface of the conductive support, wherein the insulating soft magnetic material layer contains soft magnetic powder, dielectric powder and an organic binder".

An electromagnetic interference suppression sheet is generally placed on an integrated circuit (LSI) that radiates unwanted electromagnetic waves in an electronic device or on a bus line extending from the LSI, or on wiring such as that of an FPC through which transmission noise is passing that may act as a radiant source for unwanted electromagnetic waves. One example of such a method is described in Japanese Patent Publication No. 3528427, as "a countermeasure for EMI whereby at least part of the bus line of an information processing device is coated with a composite magnetic sheet containing soft magnetic powder and an organic binder to prevent its revolution, wherein the soft magnetic powder consists of a metal magnetic body having an aspect ratio of greater than 5 and an oxide film on the surface, and the surface resistance of the composite magnetic body is at least 10³ Ω", and an embodiment is also described wherein "the composite magnetic body also has a pressure-sensitive adhesive layer composed mainly of rubber, dextrin or polyvinyl alcohol".
[Patent document 1] Japanese Unexamined Patent Publication HEI No. 07-212079
[Patent document 2] Japanese Patent Publication No. 3528427

### Brief Description of the Drawings

Fig. 1 shows a schematic cross-sectional view of an electromagnetic interference suppression sheet according to an embodiment of the invention.
Fig. 2 is a graph showing the change in the electromagnetic interference suppression effect with varying distance between the electromagnetic interference suppression layer and signal wire.
Fig. 3 is a partial plan view of a pressure-sensitive adhesive layer with a structured surface, according to an embodiment of the invention.
Fig. 4 is a cross-sectional view of a pressure-sensitive adhesive layer with a structured surface, according to an embodiment of the invention.
Fig. 5 shows the shape of structures forming the structured surface of a pressure-sensitive adhesive layer, according to an embodiment of the invention.
Fig. 6 shows the shape of structures forming the structured surface of a pressure-sensitive adhesive layer, according to another embodiment of the invention.
Fig. 7 shows a schematic cross-sectional view of an electromagnetic interference suppression sheet according to another embodiment of the invention.
Fig. 8 shows a schematic cross-sectional view of an electromagnetic interference suppression sheet according to the embodiment shown in Fig. 7, that further comprises an adhesive layer.
Fig. 9 shows a schematic cross-sectional view of an electromagnetic interference suppression sheet according to yet another embodiment of the invention.
Fig. 10 is an oblique view of a release liner according to an embodiment of the invention.
Fig. 11 shows the power loss measurement results for samples A.
Fig. 12 shows the power loss measurement results for samples B.

### Explanation of Symbols

10 Electromagnetic interference suppression sheet
20 Electromagnetic interference suppression layer
21 Soft magnetic powder
22 Dielectric powder
23 Organic binder
30 Pressure-sensitive adhesive layer
31 Structured surface
32 Trapezoidal groove
33 Structure
34 Structure side wall
35 Quadrilateral pyramidal structure
36 Truncated quadrilateral pyramidal structure
40 Reinforcing material
50 Adhesive layer
60 Release liner
61 Second structured surface
62 Protrusion

### Detailed Description

When a conventional electromagnetic interference suppression sheet such as described above is used for attachment to an adherend, air tends to become trapped between the adherend and the electromagnetic interference suppression sheet, making it necessary to remove the air after attachment or to carry out the attachment using an appropriate attachment working jig to prevent entrapment of air. The present inventors have discovered that, when air becomes entrapped, the distance between the electromagnetic interference suppression layer and adherend increases at those sections, thus reducing the electromagnetic interference suppression effect, and since the air entrapment is generally localized, the distance becomes non-uniform across the attachment surface and results in variation in the electromagnetic interference suppression effect for the attachment surface as a whole.

The present invention therefore provides an electromagnetic interference suppression sheet comprising an electromagnetic interference suppression layer that comprises a soft magnetic powder and an organic binder, and a pressure-sensitive adhesive layer having a structured surface with the side opposite the structured surface being laminated in contact with the electromagnetic interference suppression layer, **characterized in that** continuous grooves reaching to the outer perimeter of the pressure-sensitive adhesive layer are formed in the structured surface.

According to the invention, paths for air to travel outward are established between the adherend and electromagnetic interference suppression sheet when the electromagnetic interference suppression sheet is attached to its adherend, thus preventing local entrapment of air between the adherend and electromagnetic interference suppression sheet. It is therefore possible to maintain the electromagnetic interference suppression layer at a constant distance from the adherend surface without forming local air bubbles over the entire attachment surface, and consequently obtain a uniform electromagnetic interference suppression effect across the entire attachment surface.

The preceding description should not be construed as disclosing all of the embodiments of the invention nor all of the advantages of the invention.

Representative embodiments of the invention will now be explained for illustration with reference to the accompanying drawings, with the implicit understanding that the invention is not limited to these embodiments.

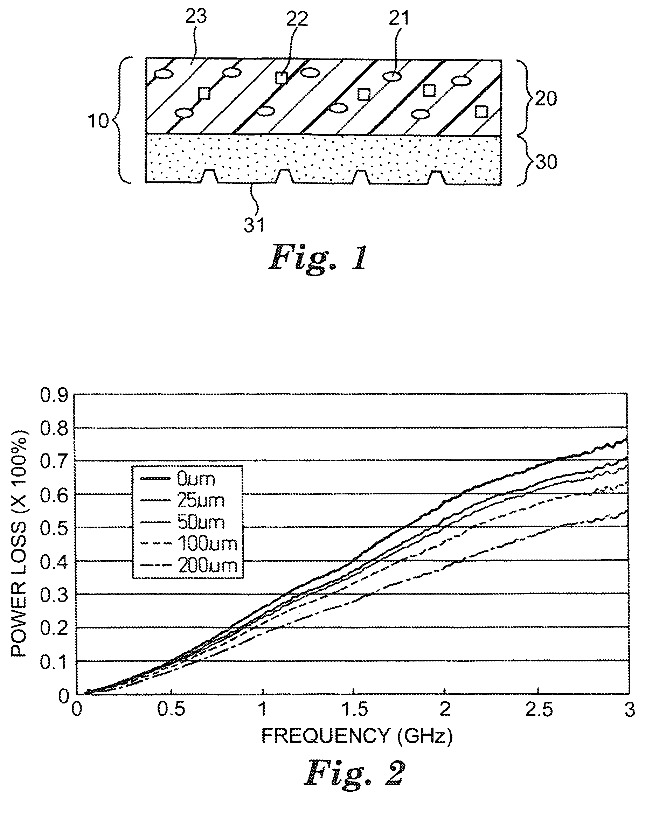

Fig. 1 shows a schematic cross-sectional view of an electromagnetic interference suppression sheet according to an embodiment of the invention. The electromagnetic interference suppression sheet 10 comprises an electromagnetic interference suppression layer 20 and a pressure-sensitive adhesive layer 30 with a structured surface 31, wherein the pressure-sensitive adhesive layer 30 is laminated so that its side opposite the structured surface 31 is in contact with the electromagnetic interference suppression layer 20. The electromagnetic interference suppression layer 20 contains a soft magnetic powder 21 and organic binder 23, and suppresses and/or absorbs unwanted electromagnetic wave interference or transmission noise passing through the wiring. In this and the other drawings, the electromagnetic interference suppression layer 20 also contains a dielectric powder 22 as an optional component. For convenience in explaining the invention, the magnetic powder 21 is shown as ovals and the dielectric powder 22 as squares, but the magnetic powder 21 and dielectric powder 22 which are actually used may of course have any different forms without being limited to these. The pressure-sensitive adhesive layer 30 is provided on an LSI or LSI bus line, or on the wiring of an FPC or the like, for placement of the electromagnetic interference suppression layer 20. The structured surface 31 formed on the pressure-sensitive adhesive layer 30 functions to prevent local entrapment of air between the electromagnetic interference suppression sheet 10 and adherend, thus allowing placement of the entire electromagnetic interference suppression layer at an essentially constant distance from the adherend surface.

The soft magnetic powder in the electromagnetic interference suppression layer is preferably a material with a high relative magnetic permeability in the high-frequency range in order to increase the electromagnetic interference suppression effect, and it is preferably a material with a relative magnetic permeability of at least 1000 and more preferably at least 10,000 when measured as a bulk material. As examples of soft magnetic powders there may be mentioned carbonyl iron, iron-aluminum-silicon alloy (sendust) and iron-nickel alloy (permalloy). The soft magnetic powder may have any desired form, but in order to further increase the electromagnetic interference suppression effect it is preferably in a flaky or acicular form, and the soft magnetic powder preferably has a large aspect ratio (for example, 5:1 or greater). The soft magnetic powder may have a coercive force of less than 100A/m as measured for the bulk magnetic body, and less 10A/m is also suitable for use.

The electromagnetic interference suppression layer may further comprise a dielectric powder as an optional component. The dielectric powder mixes with the magnetic powder, preventing contact between the particles of the magnetic powder. Preferably, the dielectric powder has a large dielectric constant in the high-frequency range and the frequency characteristic of the dielectric constant is relatively flat. As examples of dielectric powders there may be mentioned barium titanate-based ceramics, zirconate titanate-based ceramics and lead perovskite-based ceramics.

The organic binder in the electromagnetic interference suppression layer disperses in the electromagnetic interference suppression layer the soft magnetic powder and the optional dielectric powder component in an electrically insulated state, serving to bind the powders and ensure mechanical strength for the electromagnetic interference suppression layer. As organic binders there may be mentioned thermoplastic resins including polyolefins such as polyethylene or polypropylene, polystyrene, chlorinated polyethylene, polyester, polyvinyl chloride, polyvinyl butyral, polyurethane, cellulose, nitrile-butadiene, styrene-butadiene and the like, or copolymers of the above, and thermosetting resins such as epoxy resins, phenol resins, polyamides, polyimides and the like, among which polyolefins, polystyrene and chlorinated polyethylene are most commonly used.

A larger thickness of the electromagnetic interference suppression layer is more advantageous for increasing the electromagnetic interference suppression effect or electromagnetic wave absorbing effect. However, for use in smaller electronic devices such as cellular phones, digital cameras, digital video recorders, portable audio devices and the like, the electromagnetic interference suppression sheet must be as thin as possible while still exhibiting sufficient function, from the viewpoint of packaging of other electronic parts. Particularly in the case of a flexible adherend such as a high-frequency signal cable made of FPC, the electromagnetic interference suppression sheet is preferably flexible enough not to impair the flexibility of the adherend. From this viewpoint, the thickness of the electromagnetic interference suppression layer is preferably no greater than about 1 mm, and more preferably between about 0.025 mm and 0.3 mm.

Instead of lowering the thickness of the electromagnetic interference suppression sheet, using a flexible material to form the electromagnetic interference suppression sheet is also advantageous for use of the electromagnetic interference suppression sheet for a flexible adherend such as an FPC. Thus, the breaking strength of the electromagnetic interference suppression layer of the electromagnetic interference suppression sheet is preferably no greater than 14 MPa and more preferably no greater than 7 MPa as measured according to JIS K6251. An excessively low breaking strength of the electromagnetic interference suppression layer may hamper production and prevents its application to adherends, and therefore the breaking strength is preferably at least 1 MPa and more preferably at least 3 MPa.

The pressure-sensitive adhesive layer has a structured surface on the side contacting the adherend, i.e. the exposed side opposite the side in contact with the electromagnetic interference suppression layer. Continuous grooves are formed in the structured surface, defined by a plurality of structures on the surface. The grooves are continuous open channels or thin recesses, having depth in the direction of thickness of the adhesive layer from the exposed side. The groove depths may be constant or variable, and different for multiple grooves. The grooves reach the outer perimeter of the pressure-sensitive adhesive layer, or connect with other grooves reaching to the outer perimeter of the pressure-sensitive adhesive layer. The channels created by the grooves, connecting the air between the adherend and electromagnetic interference suppression sheet with the outside, i.e. the channels formed between the adherend and electromagnetic interference suppression sheet for direction of air outward, thus prevent local entrapment of air between the electromagnetic interference suppression sheet and adherend when the electromagnetic interference suppression sheet is attached to the adherend. It is therefore possible to maintain the electromagnetic interference suppression layer at a constant distance from the adherend surface without forming local air bubbles across the entire attachment surface, and consequently obtain an essentially uniform electromagnetic interference suppression effect across the entire attachment surface.

The pressure-sensitive adhesive layer may contain a pressure-sensitive adhesive, selected as appropriate for the type of adherend on which it is to be attached. Pressure-sensitive adhesives are generally classified as polyacrylates, tackifying rubber, tackifying synthetic rubber, ethylene-vinyl acetate, silicone and the like. Suitable acrylic adhesives are disclosed, for example, in U.S. Patent Nos. 3239478, 3935338, 5169727, RE 24906, 4952650 and 4181752. Preferred pressure-sensitive adhesives are reaction products of at least an alkyl acrylate and at least one reinforcing comonomer. Suitable alkyl acrylates include those with homopolymer glass transition temperatures of no higher than about - 10°C, such as n-butyl acrylate, 2-ethylhexyl acrylate, isooctyl acrylate, isononyl acrylate and octadecyl acrylate. Suitable reinforcing monomers include those with homopolymer glass transition temperatures of about -10°C such as acrylic acid, itaconic acid, isobornyl acrylate, N,N-dimethylacrylamide, N-vinylcaprolactam and N-vinylpyrrolidone.

The thickness of the pressure-sensitive adhesive layer may be varied by several factors including the distance between the electromagnetic interference suppression layer and adherend, the thickness of the electromagnetic interference suppression layer, the composition of the pressure-sensitive adhesive, the form of the structures arranged for formation of the structured surface, and the type of adherend. The thickness of the pressure-sensitive adhesive layer will generally be greater than the heights of the structures of the structured surface. The thickness of the pressure-sensitive adhesive layer referred to here is the distance in the direction normal to the attachment surface, measured from the highest point of the structures of the structured surface to the interface with the other layer or material adjacent thereto, such as the electromagnetic interference suppression layer or reinforcing material.

Fig. 2 shows the relationship of the electromagnetic interference suppression effect with the distance between the electromagnetic interference suppression layer and the noise-containing signal wire, as discovered by the present inventors. The relationship between the distance and the electromagnetic interference suppression effect is an important factor that will govern design of the thickness of the pressure-sensitive adhesive layer. A microstrip line with a length of 90 mm and a characteristic impedance of 50 Ω was used in this case. The microstrip line was attached at the center of the surface of a base with a size of 300 mm × 200 mm, a relative dielectric constant of 3.5, and having a copper foil covering the entire back side. Electromagnetic interference suppression sheets obtained by applying pressure-sensitive adhesive layers with various thicknesses to a 50 mm × 50 mm electromagnetic interference suppression layer with a thickness of 0.3 mm were placed on the microstrip line, with the electromagnetic interference suppression layers situated at different distances from the line. A distance of 0 µm from the wiring means that the electromagnetic interference suppression layer was in direct contact with the line without application of the pressure-sensitive adhesive layer. The power loss was measured according to the measuring method described in "Transmission attenuation power ratio" in IEC62333-2 (2006-05 First edition), except those mentioned as above. An HP8510C Network Analyzer by HP was used for the measurement. The power loss was calculated by the formula: Pₗₒₛₛ = 1 - |S21|² - |S11|² (where S11 is the reflection loss and S21 is the transmission loss), and a higher power loss signifies a high electromagnetic interference suppression effect.

As seen in Fig. 2, the power loss decreased as the distance between the microstrip line and electromagnetic interference suppression layer increased from 0 µm to 200 µm, with a smaller distance producing a higher electromagnetic interference suppression effect. To more effectively utilize the thin electromagnetic interference suppression layer described above, therefore, it is important to narrow the distance between the electromagnetic interference suppression layer and adherend. Moreover, because the difference in distance is closely related to the degree of electromagnetic interference suppression effect, it is important to maintain this distance essentially constant across the entire attachment surface in order to exhibit a stable electromagnetic interference suppression effect, according to the specifications of the electromagnetic interference suppression sheet, across the entire attachment surface.

As mentioned above, a smaller thickness is preferred for the pressure-sensitive adhesive layer in order to increase the electromagnetic interference suppression effect. On the other hand, the adhesive force with the adherend is reduced as the pressure-sensitive adhesive layer thickness decreases, and significant adhesive force reduction can occur with adherends having particularly high surface roughnesses. In consideration of these counter factors, therefore, the thickness of the pressure-sensitive adhesive layer is preferably between about 0.02 mm and about 1.0 mm, and more preferably between about 0.02 mm and about 0.05 mm.

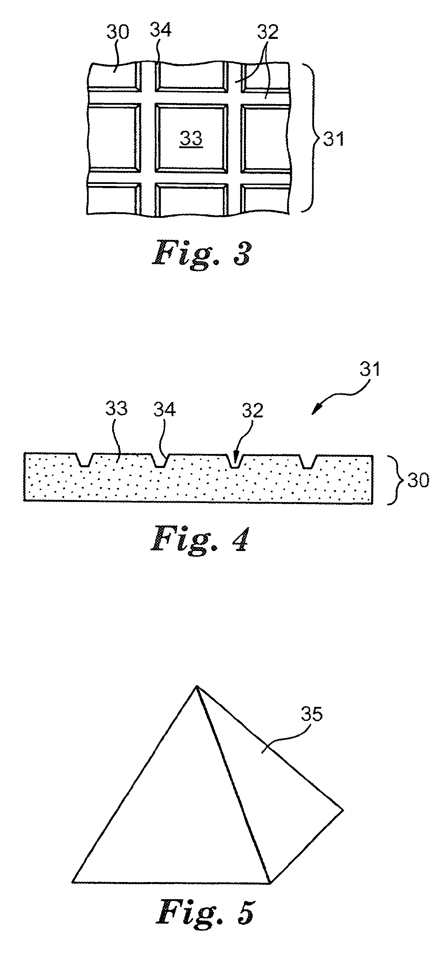

The shapes of the grooves formed in the structured surface of the pressure-sensitive adhesive layer may vary in width depending on the processing method, but they preferably have V-shaped, U-shaped, rectangular or trapezoidal cross-sections as seen from the traverse direction. Figs. 3 and 4 show, respectively, a partial plan view of the structured surface 31 and a cross-sectional view of the pressure-sensitive adhesive layer 30 having such a structured surface, as an embodiment of the invention. These drawings show trapezoidal grooves 32 in the pressure-sensitive adhesive layer 30. The trapezoidal grooves 32 and corresponding structures 33 are formed in the pressure-sensitive adhesive layer 30. The sides 34 of the structures 33 define the side walls of the grooves 32.

Grooves are usually created by embossing or forming of multiple structures in the pressure-sensitive adhesive layer. The structures may be irregularly distributed or configured in a regular pattern. The individual structures at least partially define sections of the grooves of the pressure-sensitive adhesive layer. Combining multiple structures can form continuous grooves in the structured surface of the pressure-sensitive adhesive layer.

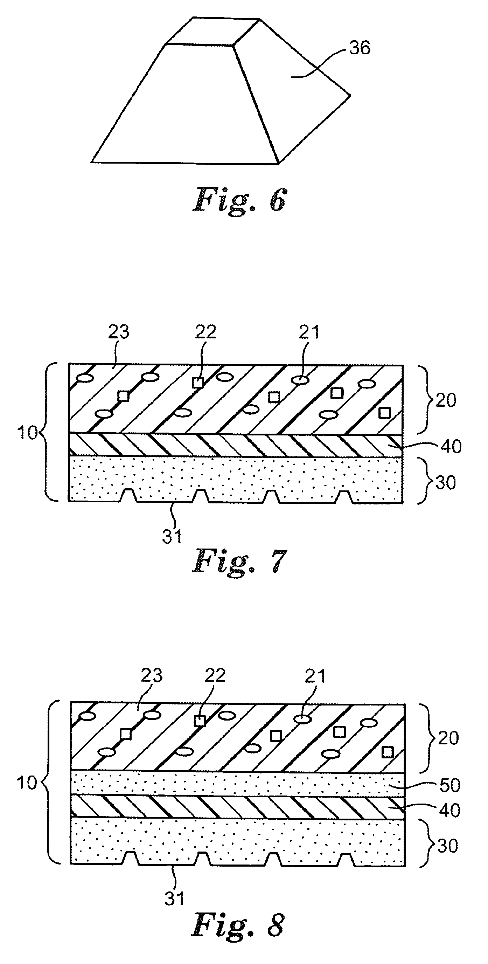

The shapes of the structures formed in the pressure-sensitive adhesive layer to produce the structured surface may be any desired shapes. Structure shapes may be selected from among semispheres, prisms (angular prisms, rectangular prisms, cylindrical prisms and prisms with similar polygonal features), pyramids and ellipsoids, although without any limitation to these. Combinations of different structure shapes may also be used. Preferred shapes are those selected from among semispheres, prisms and pyramids. The individual structures will normally have heights of at least about 3 µm and less than the total thickness of the pressure-sensitive adhesive layer, and preferably between about 3 µm and 50 µm. Fig. 5 shows a quadrilateral pyramid 35 as an embodiment of a structure suitable for use according to the invention. Fig. 6 shows an embossable truncated quadrilateral pyramid 36 in the pressure-sensitive adhesive layer, as another embodiment of a structure.

The configuration of the grooves may be any one that does not result in local entrapment of air throughout any part of the surface of the electromagnetic interference suppression sheet. This includes regular patterns and irregular patterns. As examples of groove patterns formed by groups of structures configured in regular patterns there may be mentioned perpendicular lattice, oblique lattice and hexagonal lattice patterns. The grooves may also be in a combination of multiple patterns, for example, a combination of concentric circles centered around a given point with a radial pattern that extends outward from the center point. The grooves configured in this manner either reach to the outer perimeter of the pressure-sensitive adhesive layer, or are directly or indirectly connected with other grooves that reach to the outer perimeter. This allows air bubbles to be eliminated from the electromagnetic interference suppression sheet through the grooves, regardless of where they are located.

When the group of structures is configured in a regular pattern, the average value for the pitch of the structures, i.e. the distance between corresponding points of adjacent structures, is preferably smaller to allow easier elimination of air bubbles, and the value will generally be no greater than about 0.4 mm and preferably no greater than about 0.3 mm.

The grooves have a prescribed volume per unit area of the structured surface of the pressure-sensitive adhesive layer. A larger volume of the grooves will facilitate flow of air outward from the interface between the pressure-sensitive adhesive layer and adherend. The volume of the grooves per unit area is therefore preferably at least about 1 × 10³ µm³ per arca of a 500 µm-diameter circle on the two-dimensional plane of the pressure-sensitive adhesive layer, and more preferably it is between about 1 × 10³ µm³ and about 1 × 10⁷ µm³ per area of a 500 µm-diameter circle. On the other hand, in order to ensure sufficient adhesive force of the pressure-sensitive adhesive layer for the adherend, it is essential to guarantee a prescribed contact area depending on the type of pressure-sensitive adhesive and the material and surface condition of the adherend. From this viewpoint, the initial wet out value of the pressure-sensitive adhesive layer is preferably at least about 85%.

An initial wet out test is carried out in the following manner. The test method is used to evaluate the wettability of the pressure-sensitive adhesive layer with a structured surface for a smooth transparent adherend. The device used for this method comprises a stereomicroscope (Olympus Model SZH-ZB), a microscope-mounted video camera (Cohu Model 4815), a coaxial vertical illuminator (Olympus Model TL2) and computer (Hewlett-Packard Vectra QS/20) equipped with a video digitizing board (Imaging Technologies PCVISION plus), and the video digitizing board allows the computer to photograph and digitize images. The images may then be stored and analyzed using a commercial software package (Jandel JAVA™). Light is supplied from the coaxial vertical illuminator through a lens (optical axis) to illuminate the object. The light passes through a circular polarizer mounted at the edge of a flat objective lens in the microscope. The actual procedure is carried out as follows. (1) Adhesive tape is passed once through a 2 kg roller and attached to the surface of glass (or another optically transparent flat surface). (2) The attached tape is positioned so that the interface between the adhesive and the glass can be seen through the glass with a stereomicroscope. (3) A sample is adjusted so that the glass is perpendicular to the optical axis. (4) The circular polarizer is adjusted for optimum light intensity and contrast. (5) Image analyzing software is used to capture and digitize an image. (6) The grey value window of acceptance of the software is set so as to accept only the gray values (i.e. brightness level) corresponding to the wetted regions. (7) The total wetted area 48 hours after attachment of the electromagnetic interference suppression sheet is analyzed as a percentage of the total image area.

The electromagnetic interference suppression sheet may also include a reinforcing material such as a film or nonwoven fabric. The reinforcing material is usually placed between the electromagnetic interference suppression layer and pressure-sensitive adhesive layer, but it may be situated adjacent to the electromagnetic interference suppression layer as the outermost layer of the electromagnetic interference suppression sheet. Fig. 7 is a schematic cross-sectional view of one such embodiment. In this drawing, a reinforcing material 40 such as a film or nonwoven fabric is disposed between the electromagnetic interference suppression layer 20 and the pressure-sensitive adhesive layer 30 of the electromagnetic interference suppression sheet 10. Addition of such a reinforcing material can increase the overall strength of the electromagnetic interference suppression sheet, and for example, it can prevent tearing or rupture of the electromagnetic interference suppression sheet when procedures such as reattachment are necessary. The thickness of the reinforcing material is preferably no greater than about 0.02 mm, in order to impart sufficient strength to the electromagnetic interference suppression sheet without impairing the flexibility of the electromagnetic interference suppression sheet, while maximizing the electromagnetic interference suppression effect or electromagnetic wave-absorbing effect, as explained above in regard to the thickness of the pressure-sensitive adhesive layer. The reinforcing material may be laminated on the electromagnetic interference suppression layer by co-extrusion or the like, or alternatively the reinforcing material may be incorporated into the electromagnetic interference suppression sheet by coating a composition for the electromagnetic interference suppression layer onto the reinforcing material.

An adhesive layer may be positioned between the reinforcing material and electromagnetic interference suppression layer if necessary for attachment of the reinforcing material to the electromagnetic interference suppression layer. Fig. 8 shows one such embodiment, where the reinforcing material 40 is attached to the electromagnetic interference suppression layer 20 by an adhesive layer 50. The adhesive layer may contain the same pressure-sensitive adhesive as the pressure-sensitive adhesive layer, or a different type of pressure-sensitive adhesive suited for bonding of the reinforcing material to the electromagnetic interference suppression layer. As an alternative mode, the adhesive layer may contain a permanent adhesive instead of a pressure-sensitive adhesive. The adhesive layer is used primarily for the purpose of firmly bonding the reinforcing material to the electromagnetic interference suppression layer. When the adhesive layer comprises the same pressure-sensitive adhesive as in the pressure-sensitive adhesive layer and the reinforcing material is situated between the electromagnetic interference suppression layer and pressure-sensitive adhesive layer, the adhesive layer and pressure-sensitive adhesive layer form an integral pressure-sensitive adhesive layer and the reinforcing material may be considered to be integrally disposed inside the pressure-sensitive adhesive layer. This will not only increase the overall strength of the electromagnetic interference suppression sheet, but will substantially increase the thickness of the pressure-sensitive adhesive layer, thus potentially allowing practical adhesive force to be maintained even when a thinner pressure-sensitive adhesive layer is used.

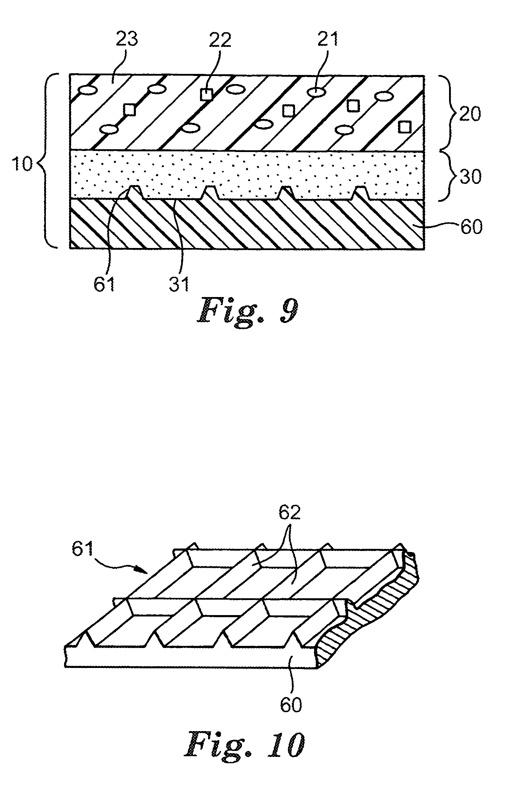

The electromagnetic interference suppression sheet may also contain a release liner with a second structured surface complementary to the structured surface of the pressure-sensitive adhesive layer. The release liner is situated with the second structured surface in contact with the structured surface of the pressure-sensitive adhesive layer. Fig. 9 is a schematic cross-sectional view of one such embodiment. In this drawing, a release liner 60 is situated on the structured surface 31 of the pressure-sensitive adhesive layer 30 of the electromagnetic interference suppression sheet 10, and the release liner 60 has a second structured surface 61 which is complementary to the structured surface 31. The second structured surface may be used to form the structured surface of the pressure-sensitive adhesive layer during production of the electromagnetic interference suppression sheet, or it may be used to hold the form of the structured surface of the pressure-sensitive adhesive layer formed in a separate step. As a modification of this embodiment, the reinforcing material and/or adhesive layer may be included in the electromagnetic interference suppression sheet. The release liner is releasable from the pressure-sensitive adhesive layer, and is used to retain adhesiveness and protect the structured surface of the pressure-sensitive adhesive layer until the electromagnetic interference suppression sheet is attached to the adherend.

The second structured surface of the release liner has a topography complementary to the structured surface of the pressure-sensitive adhesive layer, and for example, when V-shaped grooves are formed in sections of the structured surface, it has sharp protrusions at the sections corresponding to the second structured surface. Fig. 10 shows an embodiment of a release liner having such protrusions configured in an orthogonal system. The plurality of protrusions 62 are arranged orthogonally on the release liner 60 to form the second structured surface 61. When the release liner is used to form the structured surface of the pressure-sensitive adhesive layer, for example, these protrusions form V-shaped grooves in the structured surface.

The release liner may be produced from any of a variety of materials. As suitable materials there may be mentioned paper or plastic materials such as thermoplastic films, examples of which include polyethylene, polypropylene, polyester, cellulose acetate, polyvinyl chloride, polyvinylidene fluoride and the like, as well as paper coated or laminated with such plastic materials, and other materials.

Embossable coated paper or thermoplastic films may be used directly, but are preferably used after silicone treatment or treatment by other methods to improve the release property. The thickness of the release liner may vary widely according to the effect required. The thickness of the release liner will generally be between about 30 µm and about 300 µm.

The second structured surface of the release liner may be formed by a method known in the prior art. As examples of such methods there may be mentioned embossing, and other mechanical processing or etching treatment methods that are commonly employed. Embossing may be accomplished by, for example, pressing an embossing roll known as a "master tool" onto one side of the release liner.

The electromagnetic interference suppression sheet can be produced by a combination of different methods known in the prior art. An example thereof will now be explained, as a process for producing an electromagnetic interference suppression sheet having a structured surface formed on the pressure-sensitive adhesive layer using a release liner with a second structured surface. A lattice of trapezoidal grooves is formed in the structured surface of the pressure-sensitive adhesive layer. The electromagnetic interference suppression sheet also includes a reinforcing material.
(1) A release liner is provided with a structured surface having a plurality of trapezoidal protrusions in a lattice configuration, i.e. a second structured surface. As an example of a release liner suitable for use there may be mentioned a polycoat liner obtained by coating both sides of a paper base material with a polyethylene coating, although a polyester base material may be used instead of a paper base material. One of the polyethylene coatings of the release liner is release treated by coating with a silicone solution. A plurality of trapezoidal protrusions are then formed in the released treated polyethylene coating by embossing using a master tool. The surface pattern of the emboss roll is thus transferred to the polyethylene coating to obtain a release liner with a second structured surface, having a plurality of trapezoidal protrusions arranged in a lattice configuration.
(2) The second structured surface of the release liner is then coated with a pressure-sensitive adhesive to a sufficient thickness to cover the entire second structured surface, thus forming a pressure-sensitive adhesive layer. For example, the polyethylene coating of a release liner having a plurality of trapezoidal protrusions formed therein is coated with an appropriately selected pressure-sensitive adhesive to a prescribed thickness, and then dried and cured. Coating of the pressure-sensitive adhesive may be accomplished by using a coating method known in the prior art, such as one using a bar coater.
(3) A reinforcing material is laminated on the pressure-sensitive adhesive layer. The reinforcing material used may be, for example, a PET plastic film with a thickness of about 6 µm. Lamination of the reinforcing material may be accomplished using a lamination method known in the prior art, such as one using a pressure bonding roller.
(4) An adhesive layer is placed on the reinforcing material. The adhesive layer may employ the same pressure-sensitive adhesive used in step (2), for example.
(5) The method for laminating the reinforcing material is used to laminate an electromagnetic interference suppression layer on the adhesive layer to complete the electromagnetic interference suppression sheet.

The steps described above may be carried out in a different order if necessary. Other treatment steps may also be added if necessary.

The electromagnetic interference suppression sheet of the invention exhibits a particularly excellent effect when attached onto integrated circuits (LSIs) that are configured at relatively high density and that operate at high frequency in electronic devices such as cellular phones, digital video recorders, digital cameras and portable audio devices, or the bus lines extending from such LSIs, or onto wirings of FPCs and the like. It may also be attached to the enclosure walls of such electronic devices, to absorb electromagnetic waves propagated by reflection within the enclosures.

When an electromagnetic interference suppression sheet according to the invention is used, it is possible to prevent local entrapment of air between the electromagnetic interference suppression sheet and its adherend during attachment. As a result, when attachment of the electromagnetic interference suppression sheet is carried out manually, for example, it is possible to attach the electromagnetic interference suppression sheet to adherends by a simple operation that does not require a special operating jig for attachment, and thus essentially avoid the reattachment procedures that are often necessary for conventional electromagnetic interference suppression sheets. Moreover, since entrapment of air is prevented, it is possible to maintain the electromagnetic interference suppression layer at a constant distance from the adherend surface over the entire attachment surface, and thus stably obtain a uniform electromagnetic interference suppression effect across the entire attachment surface.

Furthermore, because the frequency of required reattachment procedures is greatly reduced, even an electromagnetic interference suppression sheet consisting of only an electromagnetic interference suppression layer and pressure-sensitive adhesive layer without a reinforcing material, which has somewhat lower strength, is satisfactory for practical use. If a reinforcing material is used, it is possible to reduce the thickness of the electromagnetic interference suppression layer and/or reinforcing material necessary to guarantee the required level of strength for the electromagnetic interference suppression sheet. Since an electromagnetic interference suppression sheet according to the invention can therefore be formed with a smaller thickness than a conventional electromagnetic interference suppression sheet, the electromagnetic interference suppression sheet of the invention is particularly advantageous for small-sized electronic devices that have severe restrictions on the positioning and occupying space of electromagnetic interference suppression sheets. Also, because the electromagnetic interference suppression sheet can be formed with a small thickness, a more flexible electromagnetic interference suppression sheet can be produced and as a result, the electromagnetic interference suppression sheet has greater conformability with respect to complex surface shapes and three-dimensional forms.

In addition, as mentioned above, it is possible to stably obtain a uniform electromagnetic interference suppression effect across the entire attachment area, thus eliminating the need for designs with excess thickness of the electromagnetic interference suppression layer to counter in-plane variations in the electromagnetic interference suppression effect, and this contributes to a smaller electromagnetic interference suppression sheet thickness and effective utilization of thin electromagnetic interference suppression layers.

### Examples

Representative examples will now be described in detail, and it will be appreciated by those skilled in the art that modifications and variations of the embodiments described below may be implemented within the scope of the claims of the present application.

Evaluation sample: An electromagnetic interference suppression sheet of the invention (sample A) was prepared with an electromagnetic interference suppression layer used in AB5010 (product of Sumitomo 3M, 0.1 mm thickness), over which was placed a 4 µm-thick pressure-sensitive adhesive layer, a 6 µm-thick PET film and a 30 µm-thick pressure-sensitive adhesive layer having a structured surface with lattice-like trapezoidal grooves at a groove depth of 10 µm, a groove pitch of 0.2 mm, a groove width of about 15 µm on the side bonding with the adherend, and a groove volume of about 1.2 × 10⁶ µm ³ per unit circle with a diameter of 500 µm, to fabricate the structure shown in Fig. 8. The groove dimensions were determined by measuring the shape of the second structured surface of the release liner surface used to provide a structured surface to the pressure-sensitive adhesive layer, and the groove width was defined as the width at the widest section of the trapezoidal cross-section. The electromagnetic interference suppression layer is therefore present at a position about 40 µm from the adherend surface, through a thickness of 0.1 mm. A control sample (sample B) was fabricated in the same manner as sample A, except that a pressure-sensitive adhesive layer without a structured surface was used.

Evaluation method: A microstrip line with a characteristic impedance of 50 Ω attached to a dielectric material base (TF-3B, product of Keycom, Tokyo) was used to simulate wiring for attachment of the electromagnetic interference suppression sheet. The measurement was carried out after removing the plastic film formed on the microstrip line. After positioning the electromagnetic interference suppression sheet sample A or B cut to a 40 mm square on the line and attaching the four sides to the board, the surface was rubbed with a finger to remove as much of the entrapped air bubbles as possible from between the line and sample, after which the power loss was measured as described above. The power loss was calculated by the formula: Pₗₒₛₛ = 1 - |S21|² - |S11|² (where S 11 is the reflection loss and S21 is the transmission loss), with a higher power loss signifying a greater electromagnetic interference suppression effect.

Condition of entrapped air bubbles: With sample A of the invention, it was possible to easily and completely remove air bubbles entrapped during attachment by rubbing the surface of the electromagnetic interference suppression sheet with a finger. With sample B, however, air bubbles entrapped during attachment merely shifted slightly in position when rubbed with a finger, and removal was totally impossible near the center of the attachment surface.

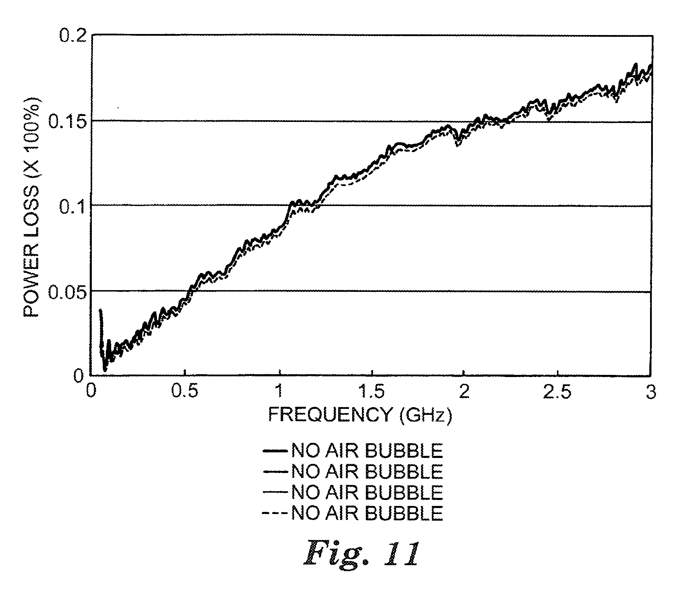

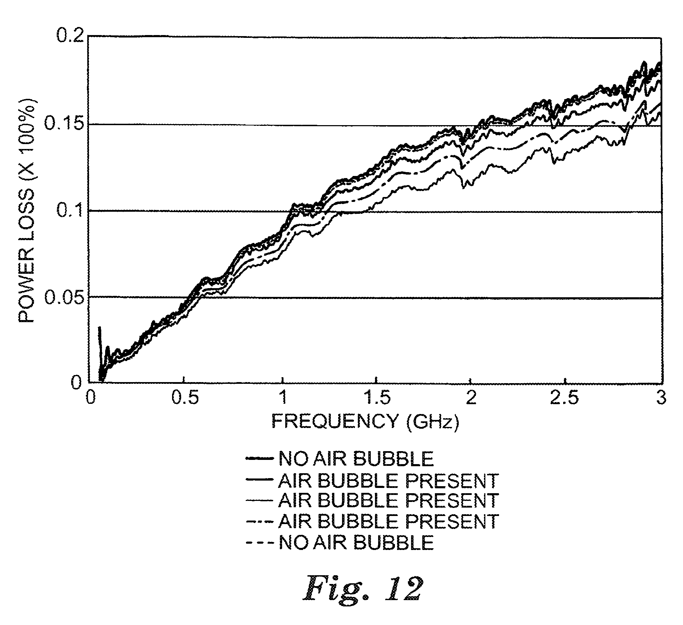

Power loss measurement results: When several samples A of the invention were prepared and attached to microstrip lines as adherends, uniform attachment could be consistently performed over the entire attachment surface without inclusion of air bubbles. Measurement of the power loss resulted in stable consistent values for the four evaluations, as shown by (1)-(4) in the graph in Fig. 11. On the other hand, with sample B corresponding to a conventional electromagnetic interference suppression sheet using a pressure-sensitive adhesive layer without a structured surface, the condition of air bubble entrapment differed for each attachment and the power loss tended to vary toward reduction among the five evaluations, as shown by (1)-(5) in the graph in Fig. 12, compared to the samples A that were completely freed of air bubbles.

## Claims

1. An electromagnetic interference suppression sheet (10) comprising
an electromagnetic interference suppression layer (20) that comprises a soft magnetic powder (21) and an organic binder (23), and
a pressure-sensitive adhesive layer (30) having a structured surface with the side opposite the structured surface being laminated in contact with the electromagnetic interference suppression layer,
**characterized in that** continuous grooves (32) reaching to the outer perimeter of the pressure-sensitive adhesive layer are formed in the structured surface.

2. An electromagnetic interference suppression sheet according to claim 1, wherein the electromagnetic interference suppression layer further contains dielectric powder.

3. An electromagnetic interference suppression sheet according to claim 1 or 2, wherein the thickness of the electromagnetic interference suppression layer is 0.025-0.3 mm.

4. An electromagnetic interference suppression sheet according to any one of claims 1 to 3, wherein the breaking strength of the electromagnetic interference suppression layer is no greater than 14 MPa.

5. An electromagnetic interference suppression sheet according to any one of claims I to 4, wherein the thickness of the pressure-sensitive adhesive layer is 0.02-1.0 mm.

6. An electromagnetic interference suppression sheet according to any one of claims 1 to 5, wherein the grooves formed in the structured surface are defined by a plurality of structures situated in a regular pattern on the surface and collectively form a pattern selected from among perpendicular lattice, oblique lattice and hexagonal lattice forms, and wherein the pitch of the plurality of structures is no greater than 0.4 mm.

7. An electromagnetic interference suppression sheet according to any one of claims 1 to 6, wherein the initial wet out value of the pressure-sensitive adhesive layer is 85% or greater, and the volume of the grooves is at least 1000 µm³ per 500 µm diameter.

8. An electromagnetic interference suppression sheet according to any one of claims 1 to 7, which further comprises a reinforcing material.

9. An electromagnetic interference suppression sheet according to claim 8, wherein the thickness of the reinforcing material is no greater than 0.02 mm.

10. An electromagnetic interference suppression sheet according to any one of claims 1 to 9, which further comprises a release liner having a second structured surface complementary to the structured surface of the pressure-sensitive adhesive layer, and situated with the second structured surface in contact with the pressure-sensitive adhesive layer.

## Patentansprüche

1. Elektromagnetische Störungen unterdrückende Folie (10), umfassend
eine elektromagnetische Störungen unterdrückende Schicht (20), die ein weichmagnetisches Pulver (21) und ein organisches Bindemittel (23) umfasst; und
eine Haftklebstoffschicht (30), die eine strukturierte Oberfläche hat, wobei die Seite gegenüber der strukturierten Oberfläche in Kontakt mit der elektromagnetische Störungen unterdrückenden Schicht laminiert ist,
**dadurch gekennzeichnet, dass** in der strukturierten Oberfläche durchgehende Nuten (32) gebildet sind, die den äußeren Rand der Haftklebstoffschicht erreichen.

2. Elektromagnetische Störungen unterdrückende Folie nach Anspruch 1, wobei die elektromagnetische Störungen unterdrückende Schicht ferner dielektrisches Pulver enthält.

3. Elektromagnetische Störungen unterdrückende Folie nach Anspruch 1 oder 2, wobei die Dicke der elektromagnetische Störungen unterdrückenden Schicht 0,025-0,3 mm beträgt.

4. Elektromagnetische Störungen unterdrückende Folie nach einem der Ansprüche 1 bis 3, wobei die Bruchfestigkeit der elektromagnetische Störungen unterdrückenden Schicht nicht größer als 14 MPa ist.

5. Elektromagnetische Störungen unterdrückende Folie nach einem der Ansprüche 1 bis 4, wobei die Dicke der Haftklebstoffschicht 0,02-1,0 mm beträgt.

6. Elektromagnetische Störungen unterdrückende Folie nach einem der Ansprüche 1 bis 5, wobei die Nuten, die in der strukturierten Oberfläche gebildet sind, durch mehrere Strukturen definiert sind, welche sich in einem regelmäßigen Muster auf der Oberfläche befinden und zusammen ein Muster bilden, das aus der Gruppe bestehend aus senkrechtem Gitter, schrägem Gitter und hexagonalem Gitter ausgewählt ist, und wobei der Abstand der mehreren Strukturen nicht größer als 0,4 mm ist.

7. Elektromagnetische Störungen unterdrückende Folie nach einem der Ansprüche 1 bis 6, wobei der anfängliche Wet-out-Wert der Haftklebstoffschicht 85 % oder mehr ist und das Volumen der Nuten mindestens 1000 µm³ pro 500 µm Durchmesser ist.

8. Elektromagnetische Störungen unterdrückende Folie nach einem der Ansprüche 1 bis 7, die ferner ein Verstärkungsmaterial umfasst.

9. Elektromagnetische Störungen unterdrückende Folie nach Anspruch 8, wobei die Dicke des Verstärkungsmaterials nicht mehr als 0,02 mm beträgt.

10. Elektromagnetische Störungen unterdrückende Folie nach einem der Ansprüche 1 bis 9, die ferner eine Abdeckfolie umfasst, welche eine zweite strukturierte Oberfläche hat, die komplementär zur strukturierten Oberfläche der Haftklebstoffschicht ist und die sich mit der zweiten strukturierten Oberfläche in Kontakt mit der Haftklebstoffschicht befindet.

## Revendications

1. Feuille de suppression des interférences électromagnétiques (10) comprenant
une couche de suppression des interférences électromagnétiques (20) qui comprend une poudre magnétique douce (21) et un liant organique (23), et
une couche d'adhésif sensible à la pression (30) ayant une surface structurée, le côté opposé à la surface structurée étant laminé en contact avec la couche de suppression des interférences électromagnétiques,
**caractérisée en ce que** des sillons continus (32) atteignant le périmètre externe de la couche d'adhésif sensible à la pression sont formés dans la surface structurée.

2. Feuille de suppression des interférences électromagnétiques selon la revendication 1, dans laquelle la couche de suppression des interférences électromagnétiques contient en outre une poudre diélectrique.

3. Feuille de suppression des interférences électromagnétiques selon la revendication 1 ou 2, dans laquelle l'épaisseur de la couche de suppression des interférences électromagnétiques est de 0,025-0,3 mm.

4. Feuille de suppression des interférences électromagnétiques selon l'une quelconque des revendications 1 à 3, dans laquelle la résistance à la rupture de la couche de suppression des interférences électromagnétiques est inférieure ou égale à 14 MPa.

5. Feuille de suppression des interférences électromagnétiques selon l'une quelconque des revendications 1 à 4, dans laquelle l'épaisseur de la couche d'adhésif sensible à la pression est de 0,02-1,0 mm.

6. Feuille de suppression des interférences électromagnétiques selon l'une quelconque des revendications 1 à 5, dans laquelle les sillons formés dans la surface structurée sont définis par une pluralité de structures disposées en un motif régulier sur la surface, et forment collectivement un motif choisi parmi des formes de réseau perpendiculaire, de réseau oblique et de réseau hexagonal, et dans laquelle le pas de la pluralité de structures est inférieur ou égal à 0,4 mm.

7. Feuille de suppression des interférences électromagnétiques selon l'une quelconque des revendications 1 à 6, dans laquelle la valeur de mouillage initiale de la couche d'adhésif sensible à la pression est de 85 % ou plus, et le volume des sillons est d'au moins 1000 µm³ pour un diamètre de 500 µm.

8. Feuille de suppression des interférences électromagnétiques selon l'une quelconque des revendications 1 à 7, qui comprend en outre un matériau de renforcement.

9. Feuille de suppression des interférences électromagnétiques selon la revendication 8, dans laquelle l'épaisseur du matériau de renforcement est inférieure ou égale à 0,02 mm.

10. Feuille de suppression des interférences électromagnétiques selon l'une quelconque des revendications 1 à 9, qui comprend en outre une doublure détachable ayant une deuxième surface structurée complémentaire de la surface structurée de la couche d'adhésif sensible à la pression, et disposée avec la deuxième surface structurée en contact avec la couche d'adhésif sensible à la pression.
